# EUROPÄISCHE PATENTSCHRIFT

(11) **EP 2 469 577 B1**
(45) Veröffentlichungstag und Bekanntmachung des Hinweises auf die Patenterteilung: **05.10.2016**
(21) Anmeldenummer: 11194788.3
(22) Anmeldetag: 21.12.2011
(51) Int. Cl.: H01J 37/20, H01J 37/305

(54) **Vorrichtung zur Kühlung von Proben während einer Ionenstrahlpräparation**
Device for cooling samples during ion beam preparation
Dispositif de refroidissement de échantillons pendant une préparation de faisceaux d'ions

(30) Priorität: 23.12.2010 AT 21372010
(43) Veröffentlichungstag der Anmeldung: 27.06.2012
(73) Patentinhaber: Leica Mikrosysteme GmbH, 1170 Wien (AT)
(72) Erfinder: Pfeifer, Thomas, 09405 Zschopau (DE); Wogritsch, Rainer, 1230 Wien (AT)
(74) Vertreter: Patentanwaltskanzlei Matschnig & Forsthuber OG

(56) Entgegenhaltungen:
- EP-A1- 1 852 888
- US-A- 3 171 957
- US-A1- 2005 218 336
- US-A1- 2006 065 853

## Beschreibung

Die Erfindung betrifft eine Kühlvorrichtung für eine Probe in einem Ionenstrahlätzverfahren, mit einem Probentisch zum Anordnen der Probe, einem ein Kühlmittel enthaltendes Kühlmittelbehältnis und zumindest einem Wärmeleitelement zum Kühlen der Probe mit Hilfe des Kühlmittels.

Die Erfindung bezieht sich weiters auf ein Verfahren zum Einstellen der Temperatur einer Probe in einem Ionenstrahlätzverfahren.

Das Ionenstrahlätzen ist ein häufig angewendetes Verfahren zum Präparieren von Proben, deren Struktur typischerweise anschließend in der Rasterelektronenmikroskopie (REM) und der Transmissionselektronenmikroskopie (TEM) untersucht wird. Diese Technik findet insbesondere in der Forschung, der Materialforschung sowie der Qualitätskontrolle vieler Werkstoffe wie Halbleiter, Metalle, Keramiken, Kunststoffe und dergleichen Anwendung. Zum Durchführen des Verfahrens werden die Proben auf einem Probentisch einer Ionenstrahlätzanlage montiert und im Strahlengang eines oder mehrerer Elektronenstrahlen justiert. Ionenstrahlätzanlagen sind typischerweise Hochvakuumanlagen, die mit einem Basisdruck von 10⁻⁶ mbar arbeiten. Als Ionen werden meistens Argon-Ionen üblicherweise bei einer Beschleunigungsspannung von 1 bis 10 kV verwendet. Die Qualität der Bildauflösung im Elektronenmikroskop ist hierbei ganz wesentlich von der Qualität der Probe abhängig. Unter den bekannten Ionenstrahlätzverfahren finden sich in Praxis insbesondere das Ionenstrahlböschungsätzen, das Ionenpolieren von REM-Proben, das Drahtabschattungsverfahren und die Ionenstrahlpräparation von TEM-Standard-Proben. Während die letzten beiden Verfahren für TEM-Proben verwendet werden, wird das Ionenstrahl-Böschungsätzen zum Herstellen von REM-Querschnittsproben genutzt. Beim Böschungsätzen werden Profile der Probe mit dem Ionenstrahl freigelegt, wobei ein Bereich der Probe durch eine auf der Oberfläche der Probe angeordnete oder zur Oberfläche der Probe justierte Maske vor der Materialabtragung durch den Ionenstrahl geschützt ist. Als besonders effektiv in der Herstellung hochqualitativer REM-Proben hat sich ein Ionenstrahl-Böschungsätzverfahren erwiesen, bei welchem zumindest zwei Ionenstrahlen, vorzugsweise drei Ionenstrahlen, unter einem vorgegebenen Winkel zueinander auf die Probenoberfläche geführt werden. Dieses Verfahren ist in der WO 2008/106815 A2 offenbart.

Bei allen Ionenätzverfahren und insbesondere bei dem Verfahren aus der WO 2008/106815 A2 ist es von Vorteil, wenn die Probe während dem Ionenstrahlätzvorgang gekühlt wird. Das Kühlen der Probe lässt höhere Strahlleistungen zu, welche wiederum - auch bei sehr empfindlichen Proben - höhere Ätzgeschwindigkeiten und folglich eine hohe Wirtschaftlichkeit bei gleichzeitig hoher Zuverlässigkeit und guter Probenqualität ermöglichen.

Kühlungen kommen in einer Vielzahl von Ionenstrahlätzanlagen zum Einsatz und werden für REM- und TEM-Präparationen sowie für spezielle Präparationstechniken wie dem oben genannten Ionenstrahl-Böschungsätzverfahren genutzt. Die Proben werden üblicherweise bei Raumtemperatur hergestellt und sind folglich bei Raumtemperatur stabil. Der hauptsächliche Zweck einer Kühlung ist daher das Aufheizen der Probe während des Ionenstrahlätzens zu vermeiden, um beispielsweise Diffusionsprozesse und Strukturänderungen zu unterbinden. Eine ausreichende Kühlung ist insbesondere bei wärmeempfindlichen Proben aus organischen Materialien, wie zum Beispiel Kunststoffen, wichtig.

In der Praxis haben sich im Wesentlichen zwei Kühlmethoden etabliert. Die erste Methode verwendet ein Peltier-Element, das zwar klein und platzsparend ausgeführt ist, jedoch für viele Anwendungen eine zu geringe Kühlleistung aufweist. Die zweite Kühlmethode umfasst die Kühlung mit einem Kühlmittel, insbesondere die Kühlung mit flüssigem Stickstoff und zeichnet sich durch eine hohe Kühlleistung aus, hat aber den Nachteil der Einhaltung von Sicherheitsvorschriften in Bezug auf das Kühlmittel. Die meisten gegenwärtigen Ionenstrahlätzanlagen arbeiten nach der zweiten Kühlmethode, wobei die Kühlung mit einer Kühlvorrichtung der eingangs genannten Art erfolgt. Viele der am Markt befindlichen Ionenstrahlätzanlagen, bei welchen die Probe zum Vermeiden von Präparationsartefakten bewegt werden muss (Rotation, Oszillation), weisen die Probleme eines unzureichenden Wärmekontakts zwischen Kühlmittel und Probe und einer eingeschränkten Temperaturmessung der Probe auf.

Ein weiteres Problem ergibt sich durch den begrenzten Kühlmittelvorrat. Bei einigen der bekannten Ionenstrahlätzanlagen wird die Probe mittels einer Schleuseneinrichtung in die Vakuumkammer geschleust. Im Servicefall bzw. wenn die Probe durch ungewolltes Lösen vom Probentisch nicht mehr aus der Vakuumkammer ausschleusbar ist, ist ein Belüften der Vakuumkammer notwendig. Hierfür muss das Kühlmittelvorratsgefäß ausgeheizt werden, um das Kühlmittel vollständig zu verdampfen. Aus diesem Grund wird bei den bekannten Anlagen nur ein begrenzter Kühlmittelvorrat eingesetzt. Da weiters keine Füllstandsanzeige bzw. Kontrolle des Kühlmittelvorrats vorhanden ist, ist der Füllstand ständig zu überwachen, wobei bei Bedarf Kühlmittel nachzufüllen ist. Der Kühlmittelvorrat würde für eine über längere Zeit unbeaufsichtigte Probenpräparation (z.B. über Nacht) nicht ausreichen. Das ständige manuelle Nachfüllen des Kühlmittels erfordert aufwendige Sicherheitsvorschriften wie das Tragen von Schutzkleidung.

Die US 2006/0065853 A1 beschreibt eine Vorrichtung zum Beeinflussen der Temperatur einer Probe in einem Focused-Ion-Beam-(FIB)-Verfahren mit Hilfe eines thermoelektrischen Moduls. Die US 2005/0218336 A1 offenbart eine Vorrichtung zum Scannen eines Wafers. Die US 3171 957 A offenbart eine Probenhalterung für ein Elektronenmikroskop.

Es ist daher eine Aufgabe der Erfindung, die aus dem Stand der Technik bekannten Nachteile zu beseitigen. Es soll insbesondere eine Kühlvorrichtung realisiert werden, bei welcher es möglich ist, gekühlte Präparationsprozesse automatisch und über einen längeren Zeitraum zu betreiben.

Diese Aufgabe wird erfindungsgemäß dadurch gelöst, dass die Kühlvorrichtung einen Kühlfinger aufweist, der mit dem zumindest einen Wärmeleitelement wärmeschlüssig verbunden ist, wobei der Probentisch über das zumindest eine Wärmeleitelement mit dem Kühlfinger wärmeschlüssig verbunden ist, und wobei der Kühlfinger einen vom Kühlmittel durchströmbaren Kanal aufweist, der mit dem Kühlmittelbehältnis verbunden ist, und durch zumindest ein weiteres Wärmeleitelement, welches sich von dem Kühlfinger zu einer Maskenhalterungseinrichtung für eine Maske erstreckt.

Dank der Erfindung kann die Kühlung des Probentisches automatisiert durch einfaches An- und Abschalten des durch den Kühlfinger strömenden Kühlmittelflusses erfolgen. Dadurch können auch größere Kühlmittelbehältnisse mit mehr Fassungsvolumen zum Einsatz kommen, da vor dem Belüften der Vakuumkammer kein umständliches Verdampfen des Kühlmittels notwendig ist. Im Gegensatz zum Stand der Technik ist dadurch ein Präparieren über einen längeren Zeitraum (z.B. über Nacht) möglich. Die Möglichkeit des raschen An- und Abschaltens der Kühlung verkürzt weiters das Ionenstrahlätzverfahren und trägt zu dessen Wirtschaftlichkeit bei. Darüber hinaus gestaltet sich die Handhabung durch den Bediener als wesentlich einfacher und sicherer, da aufgrund des größer wählbaren Fassungsvolumens keine ständige Kontrolle des Füllstands und kein ständiges Nachfüllen des Kühlmittels mehr notwendig sind.

Der kühlbare Probentisch ist als Vakuumflansch ausgebildet, der an der Vakuumkammer der Ionenstrahlätzanlage angeflanscht wird. Der Probentisch ist über zumindest ein Wärmeleitelement mit dem Kühlfinger verbunden, wobei der Kühlfinger vorzugsweise in die Vakuumkammer hineinragt. Der Kühlfinger dient neben dem Wärmetransport auch als vakuumdichte Durchführung der Kühlvorrichtung. Der Kühlfinger kann mit nur einem Wärmeleitelement, aber auch mit mehreren, beispielsweise zwei oder drei, Wärmeleitelementen mit dem Probentisch verbunden sein.

Der Begriff "wärmeschlüssig" bezieht sich auf einen ausreichenden durch den Kühlfinger und das zumindest eine Wärmelement vermittelten Wärmekontakt zwischen dem Kühlmittel und dem Probentisch, um einen guten Wärmetransport und damit eine gute Kühlung der Probe zu ermöglichen.

Das Kühlmittelbehältnis ist typischerweise ein Dewargefäß und kann - im Vergleich zum im Stand der Technik bekannten Kühlmittelbehältnis - ein wesentlich größeres Fassungsvolumen aufweisen. Vorzugsweise ist das Fassungsvolumen zumindest so groß gewählt, dass eine Probenpräparation ohne Nachfüllen des Kühlmittels und Überwachung durch einen Bediener (z.B. über Nacht) möglich ist. In der Praxis haben sich hierfür Kühlmittelbehältnisse mit einem Fassungsvolumen von 20 Litern oder mehr bewährt.

Um den Kühlmitteldurchfluss durch den Kanal des Kühlfingers zu steuern, ist es zweckmäßig, wenn die Kühlvorrichtung ein Mittel zum Steuern des Kühlmittelflusses aufweist.

Bei einer besonders bevorzugten und leicht steuerbaren Ausführungsform ist das Mittel zum Steuern des Kühlmittelflusses als Kühlmittelpumpe ausgebildet. Durch Anschalten der Kühlmittelpumpe beginnt die Kühlung des Probentisches und durch Abschalten der Kühlmittelpumpe wird sie wieder beendet. Mittels der Kühlmittelpumpe ist weiters die Durchflussrate des Kühlmittels durch den Kanal des Kühlfingers einfach und effizient über die Pumpendrehzahl einstell- und steuerbar.

Bei einer weiteren Ausführungsform kann das Mittel zum Steuern des Kühlmittelflusses als Ventilelement ausgebildet sein. Das Ventilelement ermöglicht jedoch nur ein An- und Abschalten des Kühlmittelflusses durch den Kanal des Kühlfingers. Da das Kühlmittel nicht aktiv durch den Kühlfinger geleitet wird, muss das Kühlmittelbehältnis auch höher als der Kühlfinger angeordnet sein. Aus diesen Gründen wird die Ausführungsform mit der Kühlmittelpumpe, bei welcher ferner eine Steuerung der Durchflussrate möglich ist, bevorzugt.

Bei einer weiteren Ausführungsform kann das Mittel zum Steuern des Kühlmittelflusses als eine Kombination aus Kühlmittelpumpe und Ventilelement ausgebildet sein. Hierbei wird die Pumpleistung konstant gehalten und die Durchflussrate über die Öffnung eines regelbaren Ventils, vorzugsweise eines Durchflussreglers, geregelt.

Bei einer bevorzugten Ausführungsform ist der Kühlfinger doppelwandig ausgebildet, wobei der Kühlfinger vorzugsweise ein äußeres Rohr und ein im äußeren Rohr angeordnetes inneres Rohr umfasst. Das Kühlmittel fließt dabei vorzugsweise durch das innere Rohr in den Kühlfinger hinein und durch das äußere Rohr wieder aus diesem hinaus.

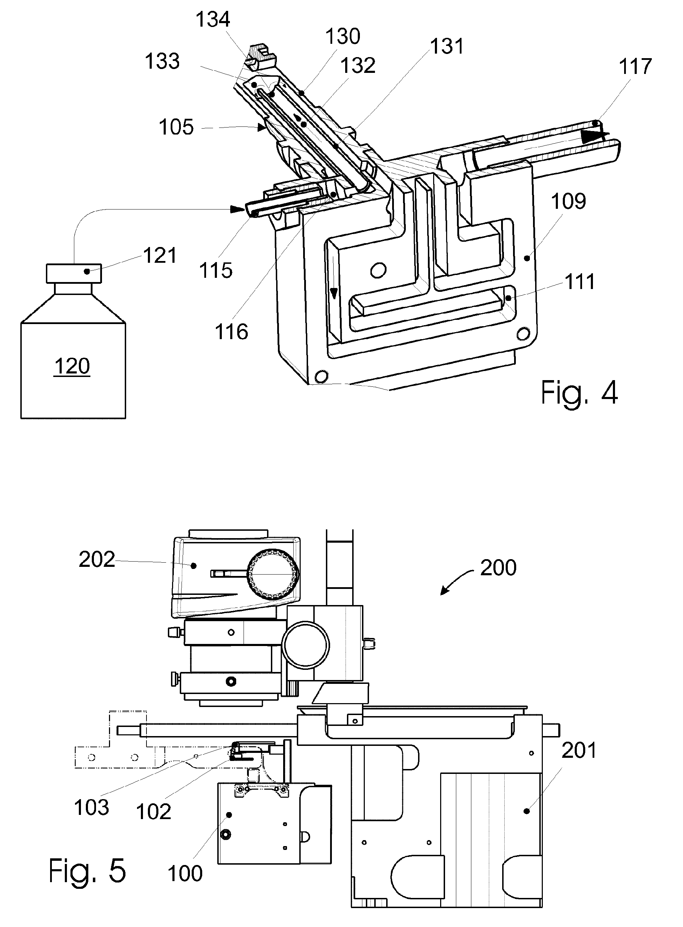

Wie weiter unten in der Fig. 4 genauer dargestellt ist, ist das Wärmeleitelement vorzugsweise an einem zum Kühlfinger gerichteten Ende in eine Kontakthülse eingepresst und anschließend an den Kühlfinger befestigt. Die Befestigung kann beispielsweise durch Anschrauben oder Festklemmen der Kontakthülse an den Kühlfinger erfolgen. Eine gute wärmeschlüssige Verbindung und folglich eine starkes Abkühlen des Probentisches kann insbesondere durch einen großflächigen und ebenen Kontakt der Kontakthülse zum Kühlfinger und ferner durch festes Anschrauben bzw. Anklemmen gewährleistet werden. Beispielsweise ist mit einer Kontaktfläche von 10x10 mm zwischen Kontakthülse und Kühlfinger eine gute wärmeschlüssige Verbindung erreichbar.

Die mittels der Kühlung am Probentisch minimal erreichbare Temperatur ist also nicht nur vom verwendeten Kühlmittel, sondern auch entscheidend von der Wärmeleitung zwischen dem Kühlmittel und dem Probentisch abhängig. Auf der einen Seite befindet sich das Kühlmittel, welches durch den Kanal des Kühlfingers strömt und eine gewisse Temperatur aufweist, z.B. <-195,8°C im Falle des flüssigen Stickstoffs. Auf der anderen Seite befindet sich der zu kühlende Probentisch, der nicht vollständig thermisch isoliert ist und dem von außen, z.B. durch die Ionenquellen, ständig Wärme zugeführt wird bzw. der ständig "Kälte" verliert. Auch an den Übergangsstellen, an denen das Wärmeleitelement mit dem Probentisch bzw. mit dem Kühlfinger verbunden ist, kann Wärme verloren gehen. Neben der oben bereits erläuterten Verbindung des Wärmeleitelements mit dem Kühlfinger ist auch die Ausführung des Wärmeleitelements selbst von Bedeutung. Das Wärmeleitelement ist folglich aus einem gut wärmeleitenden Material, vorzugsweise Kupfer, hergestellt. Das Wärmeleitelement ist vorzugsweise bandförmig ausgebildet. Vorzugsweise werden für das Wärmeleitband größere Querschnitte gewählt, da diese einen höheren Wärmetransport und damit tiefere Temperaturen ermöglichen. In der Praxis haben sich Querschnitte von beispielsweise 1 x 6 mm² und 2 x 6 mm² als günstig erwiesen, wobei mit dem größeren Querschnitt von 2 x mm² ein besserer Wärmetransport möglich ist.

Bei einer besonders vorteilhaften Ausführungsform ist zumindest ein weiteres Wärmeleitelement vorgesehen, welches sich von dem Kühlfinger zu einer Maskenhalterungseinrichtung für eine Maske erstreckt, wobei die Probe relativ zur Maske positionierbar ist. Typischerweise wird die Probe vor dem Ionenstrahlätzvorgang relativ zur Maske positioniert. Bei dieser Ausführungsform wird somit nicht nur der Probentisch samt darauf montierter Probe, sondern auch die Maskenhalterungseinrichtung samt Maske gekühlt. Die gleichzeitige Kühlung des Probentisches und der Maskenhalterungseinrichtung verhindert eine Drift aufgrund einer Wärmeausdehnung zwischen der relativ zur Probe positionierten Maskenkante und dem zur Maskekante positionierten Probenbereich. Die Eigenschaften des Wärmeleitelements, welches die Maskenhalterungseinrichtung und den Kühlfinger verbindet, entsprechen jenen des Wärmeleitelements, welches den Probentisch mit dem Kühlfinger verbindet. Der Kühlfinger kann mit nur einem Wärmeleitelement, aber auch mit mehreren, beispielsweise zwei oder drei, Wärmeleitelementen mit der Maskenhalterungseinrichtung verbunden sein. Bezüglich des Querschnitts der Wärmeleitelemente haben sich in der Praxis für eine gleichmäßige Kühlung von Probentisch und Maske beispielsweise ein Querschnitt von 2x6 mm² für das sich zum Probentisch erstreckende Wärmeleitband und ein Querschnitt von 1x6 mm² für das sich zum Maskenhalter erstreckende Wärmeleitband als günstig herausgestellt.

Es hat sich ferner als günstig erwiesen, wenn der Kanal des Kühlfingers in einen Verdampferblock zum Verdampfen des aus dem Kühlfinger ausströmenden Kühlmittels mündet. Das Kühlmittel ist zweckmäßigerweise ein Flüssiggas, insbesondere flüssiger Stickstoff oder flüssige Luft. Das Kühlmittel wird folglich vom Kühlmittelbehältnis durch den Kanal des Kühlfingers und von dort weiter in das Röhrensystem eines Verdampferblocks geleitet. Das Kühlmittel wird im Verdampferblock verdampft. Dies hat den Vorteil, dass am Ende des Durchlaufs durch den Verdampferblock nur mehr geringe Mengen des flüssigen Kühlmittels und vorzugsweise nur mehr gasförmiges Kühlmittel austreten. Umfasst die Kühlvorrichtung eine Kühlmittelpumpe, dann kann die Durchflussrate des Kühlmittels über die Pumpendrehzahl der Kühlmittelpumpe so geregelt sein, dass nur mehr gasförmiges Kühlmittel aus dem Verdampferblock austritt.

Bei einer vorteilhaften Variante sind dem Verdampferblock ein Temperaturmessmittel zum Messen der Temperatur des Verdampferblocks und/ oder ein Heizelement zugeordnet.

Bei einer weiteren vorteilhaften Variante sind dem Probentisch ein Temperaturmessmittel zum Messen der Temperatur des Probentisches und/ oder ein Heizelement zugeordnet.

Es ist dabei von Vorteil, wenn die Temperatur des Probentischs und/oder des Verdampferblocks regelbar ist. Zweckmäßigerweise ist der Kühlvorrichtung daher eine Temperaturregeleinrichtung zum Regeln der Temperatur des Probentisches und/ oder der Temperatur des Verdampferblocks zugeordnet, wobei ein der Temperatur des Probentisches und/oder der Temperatur des Verdampferblocks entsprechendes Signal der Temperaturregeleinrichtung zugeführt ist, welche die Temperatur des Probentisches und/oder die Temperatur des Verdampferblocks auf einen vorgebbaren Wert regelt. Die Temperatur der Maske zeigt bei zeitgleicher Kühlung mit dem Probentisch ein annähernd gleiches Temperaturverhalten wie der Probentisch. Dies ist, wie oben bereits beschrieben wurde, von den jeweiligen Querschnitten der Wärmeleitbänder abhängig, wobei die optimalen Querschnitte von einem Fachmann anhand von Routineversuchen festgestellt werden können. Die Maskentemperatur ist bei dieser Ausführungsform an die Regelung der Probentischtemperatur gekoppelt und muss nicht extra überwacht werden.

Bei einer Weiterbildung ist auch der Maskenhalterung ein Temperaturmessmittel zum Messen der Temperatur der Maskenhalterung und der Maske zugeordnet, wobei diese Temperatur ebenfalls mittels der Temperaturregeleinrichtung geregelt wird. Aus Gründen der Einfachheit ist es jedoch bevorzugt, der Maskenhalterung kein eigenes Temperaturmessmittel zuzuordnen, sondern die Maskentemperatur wie oben beschrieben an die Regelung der Probentischtemperatur zu koppeln.

Bei einer ersten vorteilhaften Variante regelt die Temperaturregeleinrichtung die Temperatur des Probentisches und/ oder des Verdampferblockes über die Pumpendrehzahl der Kühlmittelpumpe auf einen vorgebbaren Wert.

Bei einer zweiten vorteilhaften Variante regelt die Temperaturregeleinrichtung die Temperatur des Probentisches mittels des dem Probentisch zugeordneten Heizelements auf einen vorgebbaren Wert.

Bei vielen Anwendungen wird der Temperaturwert möglichst niedrig gewählt und während des gesamten Ionenstrahlätzvorgangs auf konstantem Niveau gehalten. In Versuchen hat sich gezeigt, dass mit der erfindungsgemäßen Vorrichtung die zu präparierende Probe auf eine Temperatur von < -150°C abkühlbar ist.

Der Vorteil der zweiten Variante gegenüber der ersten Variante liegt darin, dass auf gewünschte Änderungen der Temperatur rascher reagiert werden kann. Die zweite Variante findet daher insbesondere in Fällen Anwendung, in welchen die Temperatur der Probe wesentlich höher als die durch Kühlung minimal erreichbare Temperatur sein soll oder wenn während dem Ionenstrahlätzvorgang eine Änderung der Probentemperatur (z.B. Temperaturgradient) gewünscht ist. Die Regelung der Probentemperatur über die Pumpendrehzahl der Kühlmittelpumpe könnte sich in diesen Fällen als zu träge erweisen und die zweite Variante wäre demnach zu bevorzugen. Ob für einen bestimmten Ionenstrahlätzvorgang die erste oder die zweite Variante besser geeignet ist, kann ein Fachmann anhand der Vorrichtungsparameter und gegebenenfalls anhand von einfachen Routineversuchen fallspezifisch entscheiden.

Die meisten, oben im Stand der Technik beschriebenen Ionenstrahlätzanlagen sehen keine Möglichkeit der kontrollierten automatischen Probenaufheizung nach dem Ionenstrahlätzvorgang vor. Es besteht daher immer die Gefahr der Verschmutzung der Probe mit Kondenswasser bei Belüftung der Ionenstrahlätzanlage (Betauung).

Um zu verhindern, dass die Probe nach Fertigstellung beim Belüften und Öffnen des Probentischflansches mit Kondenswasser der Umgebungsluft kontaminiert wird, ist es von Vorteil, wenn die Temperaturregeleinrichtung die Temperatur des Probentisches und des Verdampferblockes mittels des dem Verdampferblock zugeordneten Heizelements nach Beendigen des Ionenstrahlätzvorgangs auf einen Temperaturwert regelt, bei welchem ein Niederschlagen der Luftfeuchte der Umgebungsluft auf der Probe verhindert wird. Wie bereits oben erwähnt, zeigt die Maske ein annähernd gleiches Temperaturverhalten wie der Probentisch. Der Kühlmittelfluss durch den Kühlfinger wird üblicherweise vor dem Aufwärmen gestoppt. Vorteilhafterweise wird die Temperatur auf Raumtemperatur geregelt.

Es ist weiters eine Aufgabe der Erfindung ein Verfahren zum Einstellen der Temperatur unter Verwendung der erfindungsgemäßen Kühlvorrichtung bereit zu stellen.

Diese Aufgabe wird erfindungsgemäß mit einem Verfahren zum Einstellen der Temperatur einer Probe in einem Ionenstrahlätzverfahren gelöst, wobei das Verfahren die folgenden Schritte umfasst:
(a) Befestigen einer Probe auf einem kühlbaren Probentisch einer Ionenstrahlätzvorrichtung, wobei der Probentisch einer zuvor beschriebenen Kühlvorrichtung zugeordnet ist, und Justieren der Probe auf dem Probentisch, und
(b) Abkühlen der Probe mittels des durch den Kanal des Kühlfingers geleiteten Kühlmittels, wobei eine für den Ionenstrahlätzvorgang gewünschte Temperatur eingestellt wird.

Vorzugsweise umfasst das Verfahren einen auf Schritt (b) folgenden Schritt (c), bei welchem nach Beendigung des Ionenstrahlätzvorgangs die Kühlung der Probe beendet wird. Hierfür wird die Kühlmittelzufuhr, die wie oben beschrieben über eine Kühlmittelpumpe oder ein Ventil gesteuert sein kann, gestoppt.

Vorzugsweise umfasst das Verfahren weiters einen auf Schritt (c) folgenden Schritt (d), bei welchem die Probe auf eine Temperatur aufgewärmt wird, bei welcher ein Niederschlagen der Luftfeuchte der Umgebungsluft auf der Probe verhindert wird. Vorzugsweise wird die Probe auf Raumtemperatur aufgewärmt.

Wird die Probe in einem Ionenstrahlätzverfahren relativ zu einer Maske justiert, ist es von Vorteil, wenn die Maske analog zur Probe abgekühlt bzw. wieder auf Raumtemperatur aufgewärmt wird. Wie bereits erwähnt verhindert die gleichzeitige Kühlung des Probentischs und der Maskenhalterungseinrichtung eine Drift aufgrund einer Wärmeausdehnung zwischen der relativ zur Probe positionierten Maskenkante und dem zur Maskekante positionierten Probenbereich. Die Temperatur der Maske zeigt bei zeitgleicher Kühlung sowie beim Aufwärmen mit dem Probentisch ein annähernd gleiches Temperaturverhalten wie der Probentisch. Die Maskentemperatur ist somit an die Probentischtemperatur gekoppelt und muss nicht extra überwacht werden.

Bei den meisten Ionenstrahlätzanwendungen ist es vorgesehen, dass die Temperatur der Probe während des Ionenstrahlätzvorgangs konstant gehalten wird.

Wie oben bereits angesprochen, ist das Kühlmittel zweckmäßigerweise ein Flüssiggas, vorzugsweise flüssiger Stickstoff oder flüssige Luft. Meistens wird bei Ionenstrahlätzverfahren flüssiger Stickstoff verwendet. Bei einer bevorzugten Ausführungsform wird die Durchflussrate des Kühlmittels, z.B. über die Pumprate der Kühlmittelpumpe, so eingestellt wird, dass nach Durchfließen des Verdampferblocks das Kühlmittel nur mehr gasförmig aus diesem austritt. Dadurch wird erstens das Risiko des Inkontaktkommens des Bedieners mit dem Flüssiggas gesenkt und zweitens ein übermäßiger Kühlmittelverbrauch verhindert.

Im Folgenden wird die Erfindung samt weiteren Vorzügen anhand von nicht einschränkenden Ausführungsbeispielen erläutert, die in den beigefügten Zeichnungen dargestellt sind. Die Zeichnungen zeigen:
Fig. 1 Eine perspektivische Ansicht eines Probentischflansches mit einer erfindungsgemäßen Kühlvorrichtung mit Blick auf den Probentisch,
Fig. 2 den Probentischflansch aus der Fig. 1 mit Blick auf den Verdampferblock der Kühlvorrichtung,
Fig. 3 eine perspektivische Ansicht auf Komponenten einer erfindungsgemäßen Kühlvorrichtung,
Fig. 4 eine Darstellung des Verlaufs des Kühlmittels durch die Kühlvorrichtung,
Fig. 5 eine Seitenansicht einer geöffneten Ionenstrahlätzanlage mit dem darin montierten Probentischflansch aus der Fig. 1 in Justierposition,
Fig. 6 die Ionenstrahlätzanlage aus der Fig. 5, wobei der Probentischflansch in die Schließposition geschwenkt ist,
Fig. 7 einen Schnitt durch die geschlossene Vakuumkammer der Ionenstrahlätzanlage der Fig. 5 und Fig. 6, wobei der Probentischflansch in Betriebsposition ist,
Fig. 8 eine erste Variante eines Schaltbilds eines Regelkreises zum Regeln der Temperatur der Probe,
Fig. 9 eine zweite Variante eines Schaltbilds eines Regelkreises zum Regeln der Temperatur der Probe,
Fig. 10 ein Schaltbild eines Regelkreises zum Regeln der Temperatur des Verdampferblocks,
Fig. 11 ein Schaltbild, welches die Ablaufsteuerung der Kühlung darstellt,
Fig. 12 ein Schaltbild eines Regelkreises zum Regeln der Temperatur beim Aufheizen nach Beendigung des Ionenstrahlätzvorgangs,
Fig. 13 ein Schaltbild, welche die Ablaufsteuerung des Aufheizens darstellt.

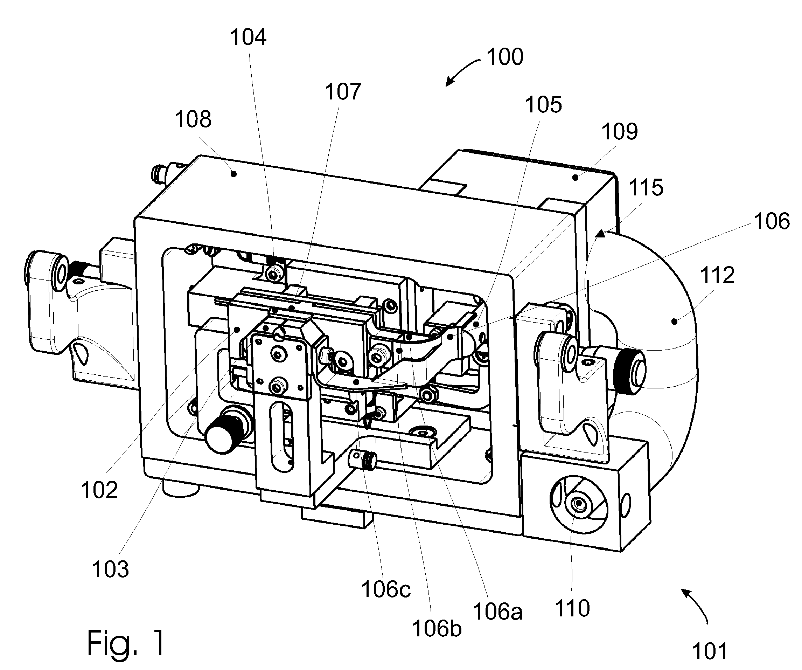

Fig. 1 zeigt einen Probentischflansch 100, welcher für ein Ionenstrahl-Böschungsätzverfahren konzipiert und welchem eine erfindungsgemäße Kühlvorrichtung 101 zugeordnet ist. Der Probentischflansch 100 ist vakuumdicht an einer Ionenstrahlätzanlage (Ionenstrahlätzanlage 200, siehe Fig. 5 bis Fig. 7) montierbar. Die Kühlvorrichtung 101 umfasst einen kühlbaren Probentisch 102, auf welchem die nicht dargestellte Probe montierbar ist, sowie einen kühlbaren Maskenhalter 103 mit einer Maske 104. Weiters umfasst die Kühlvorrichtung 101 einen Kühlfinger 105. Der Probentisch 102 und der Maskenhalter 103 sind mit dem Kühlfinger 105 über Wärmeleitbänder 106a,106b,106c wärmeschlüssig verbunden, so dass der Maskenhalter 103 und die Maske 104 zeitgleich mit dem Probentisch 102 und der Probe gekühlt werden. Die Querschnitte der Wärmeleitbänder 106a,106b,106c sind derart gewählt, dass eine gleichmäßige Kühlung von Probentisch 102 und Maskenhalter 103 erfolgt. Die Wärmeleitbänder 106a,106b,106c erstrecken sich von einem gemeinsamen Ursprung 106 am Kühlfinger 105 zum Probentisch 102 (Wärmeleitbänder 106a,106b und zum Maskenhalter 103 (Wärmeleitband 106c). Die Probe wird vor Beginn des Ionenstrahlätzvorgangs relativ zur Maske 104 positioniert. Die gleichzeitige Kühlung des Probentischs 102 und des Maskenhalters 103 verhindert eine Drift aufgrund einer Wärmeausdehnung zwischen einer relativ zur Maskenkante 107 positionierten Probe und dem zur Maskekante 107 positionierten Probenbereich.

Der Probentisch 102, der Maskenhalter 103, die Wärmeleitbänder 106a,106b,106c und der Kühlfinger 105 sind innerhalb des Gehäuses 108 des Probentischflansches 100 angeordnet. Außerhalb des Probentischflansches 100 ist ein Verdampferblock 109 angebracht. Der Kühlfinger 105, der auch mit dem Verdampferblock 109 verbunden ist, erstreckt sich durch das Gehäuse 108 des Probentischflansches 100 und ist folglich vakuumdicht ausgeführt. Der Kühlfinger 105 ist doppelwandig ausgebildet (siehe Schnittdarstellung durch den Kühlfinger der Fig. 4) und wird nahezu vollständig mit dem Kühlmittel, welches in diesem Fall flüssiger Stickstoff ist, durchströmt.

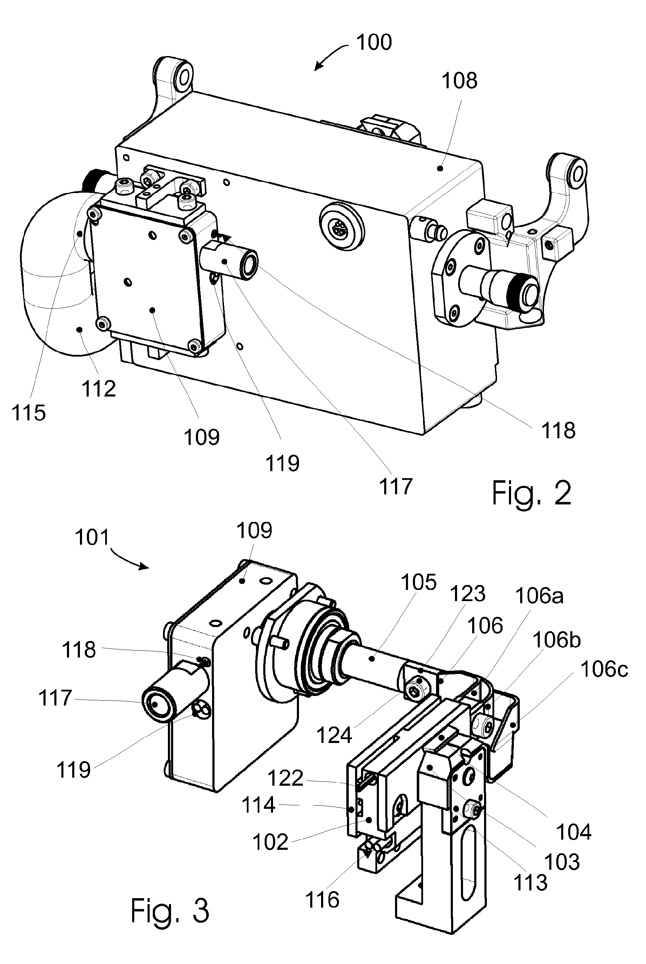

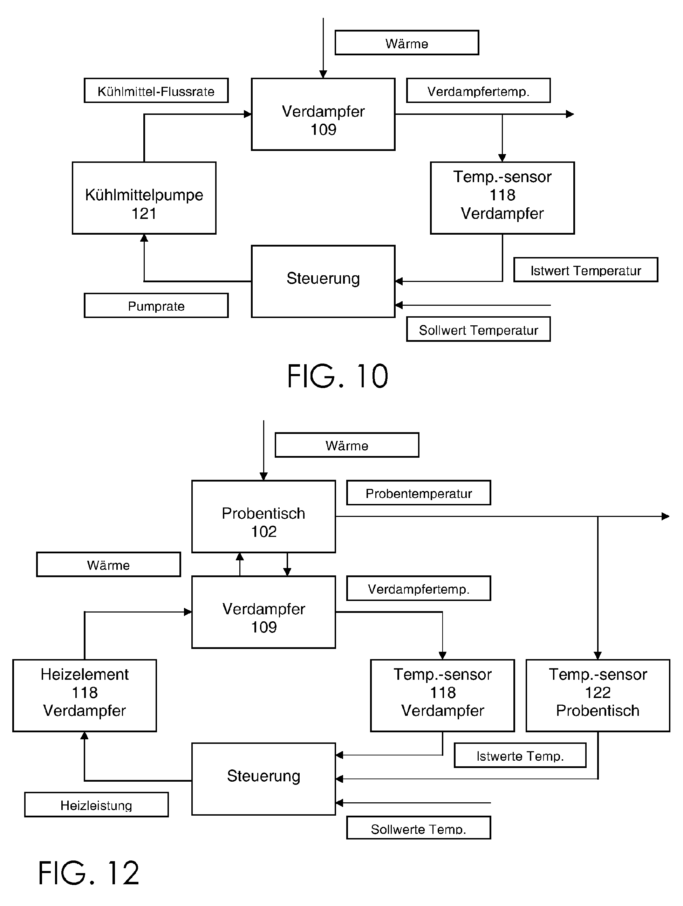

Das Kühlmittel befindet sich in einem Vorratsbehältnis 120 (Dewargefäß) und wird von dort mittels einer Kühlmittelpumpe 121 (siehe Fig. 4), deren Anschluss 110 sich am Gehäuse 108 des Probentischflansches 100 befindet, über eine ummantelte Kühlmittelleitung 112 zum Einlass 115 des Verdampferblocks 109 gepumpt. Die Fig. 2 zeigt eine Rückansicht des Probentischflansches 100 mit Blick auf den Verdampferblock 109. Zur Kontrolle und Regelung der Temperatur des Verdampferblocks 109 ist innerhalb des Verdampferblocks 109 ein Temperaturfühler 118 angeordnet. Weiters ist im Verdampferblock 109 ein Heizelement 119 angeordnet, welches nach Beendigung des Ionenstrahlätzvorgangs zum Aufheizen des gesamten Probentischflansches 100 auf vorzugsweise Raumtemperatur dient (siehe Fig. 12). Vom Einlass 115 des Verdampferblocks 109 wird das Kühlmittel anschließend in den Kühlfinger 105 ein- und wieder ausgeleitet. Das ausgeleitete Kühlmittel durchfließt ein Röhrensystem 111 innerhalb des Verdampferblocks 109 und wird dort verdampft, wobei vorzugsweise beim Auslass 117 des Verdampferblocks 109 nur mehr gasförmiges Kühlmittel (gasförmiger Stickstoff) austritt. Der Verlauf des Kühlmittels durch die Kühlvorrichtung ist unten in der Fig. 4 nochmals im Detail beschrieben.

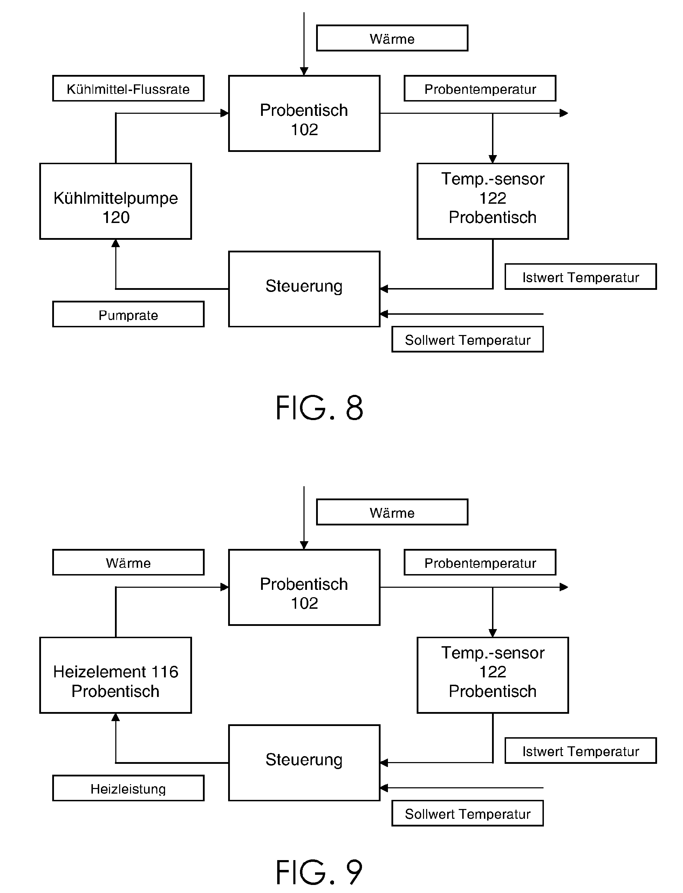

Die Fig. 3 stellt eine perspektivische Ansicht auf Komponenten der erfindungsgemäßen Kühlvorrichtung 101, wie sie im Probentischflansch 100 eingebaut sind, dar. Die dargestellten Komponenten umfassen den Probentisch 102, den Maskenhalter 103 mit der darauf befindlichen Maske 104, den Verdampferblock 109, den Kühlfinger 105 und die Wärmeleitbänder 106a,106b,106c. Die Wärmeleitbänder 106a,106b,106c erstrecken sich von dem gemeinsamen Ursprung 106 am Kühlfinger 105 zum Probentisch 102 (Wärmeleitbänder 106a,106b und zum Maskenhalter 103 (Wärmeleitband 106c). Der Ursprung 106 der Wärmeleitbänder 106a,106b,106c ist in eine Kontakthülse 123 eingepresst und wird anschließend an den Kühlfinger 105 mittels einer Befestigungsschraube 124 befestigt. Die Kontaktfläche zwischen der Kontakthülse 123 und dem Kühlfinger 105 ist so gewählt, dass eine gute wärmeschlüssige Verbindung erreichbar ist. Im gezeigten Beispiel beträgt die Kontaktfläche zwischen der Kontakthülse 123 und dem Kühlfinger 105 ungefähr 10x10 mm. Weitere Komponenten der Kühlvorrichtung 101 wie das Vorratsgefäß 120 für das Kühlmittel sowie die Kühlmittelpumpe 121, die in der Fig. 3 nicht dargestellt sind, sind unten in der Fig. 4 dargestellt. Der Probentisch 102 und der Maskenhalter 103 sind gegenüber den anderen Bauteilen des Probentischflansches 100 durch angrenzende, schlecht wärmeleitende Elemente 113,114 wärmeisoliert, um den Wärmeverlust möglichst gering zu halten. Zur Kontrolle und Regelung der Temperatur des Probentisches 102 befindet sich innerhalb des Probentisches 102 noch ein Temperaturfühler 122. Weiters kann bei einer Regelkreisvariante zur Regelung der Temperatur des Probentisches 102, die weiter unten beschrieben wird (siehe Fig. 9), innerhalb des Probentisches 102 noch ein Heizelement 116 angeordnet sein.

Die Fig. 4 veranschaulicht den Verlauf des Kühlmittels durch die Kühlvorrichtung 100. Das Kühlmittel wird in einem Vorratsgefäß 120 gelagert. Vorzugsweise ist das Fassungsvolumen des Vorratsgefäßes 120 zumindest so groß gewählt, dass eine Probenpräparation ohne Nachfüllen des Kühlmittels und Überwachung durch einen Bediener (z.B. über Nacht) möglich ist. In der Praxis haben sich hierfür Kühlmittelbehältnisse mit einem Fassungsvolumen von 20 Litern oder mehr bewährt. Vor Beginn des Ionenstrahlätzvorgangs wird die Kühlung des Probentisches 102 und des Maskenhalters 103 durch Einschalten der Kühlmittelpumpe 120 gestartet. Hierfür wird das Kühlmittel mittels der Kühlmittelpumpe 121 aus dem Vorratsgefäß 120 zum Eingang 115 des Verdampferblocks 109 und über einen Kühlfingeranschluss 116 in Richtung des doppelwandigen Kühlfingers 105 gepumpt. Der Kühlfinger 105 umfasst ein äußeres Rohr 130 und ein im äußeren Rohr 130 angeordnetes inneres Rohr 131. Die Fließrichtung des Kühlmittels ist durch die Pfeile 132, 133 dargestellt. Das Kühlmittel (flüssiger Stickstoff) strömt durch das innere Rohr in den Kühlfinger 105 hinein (Pfeil 132) und gelangt durch eine Rohröffnung 134 des inneren Rohres 131 in das äußere Rohr 130. Von dort strömt es in entgegen gesetzter Richtung (Pfeil 133) wieder aus dem Kühlfinger 105 hinaus und gelangt von dort weiter in das Röhrensystem 111 des Verdampferblocks 109, wo es verdampft wird. Die Durchflussrate des Kühlmittels wird mittels der Pumpendrehzahl der Kühlmittelpumpe 120 vorzugsweise so geregelt, dass nach dem Durchlaufen des Röhrensystems 111 am Auslass 117 des Verdampferblocks 109 nur mehr gasförmiges Kühlmittel (gasförmiger Stickstoff) austritt. Die Regelung der Temperatur wird weiter unten genauer erläutert. Nach Beendigung des Ionenstrahlätzvorgangs wird die Kühlung durch Ausschalten der Kühlmittelpumpe 121 gestoppt und alle gekühlten Komponenten des Probentischflansches werden mittels des Heizelements 119 des Verdampferblocks 109 vorzugsweise auf Raumtemperatur aufgeheizt.

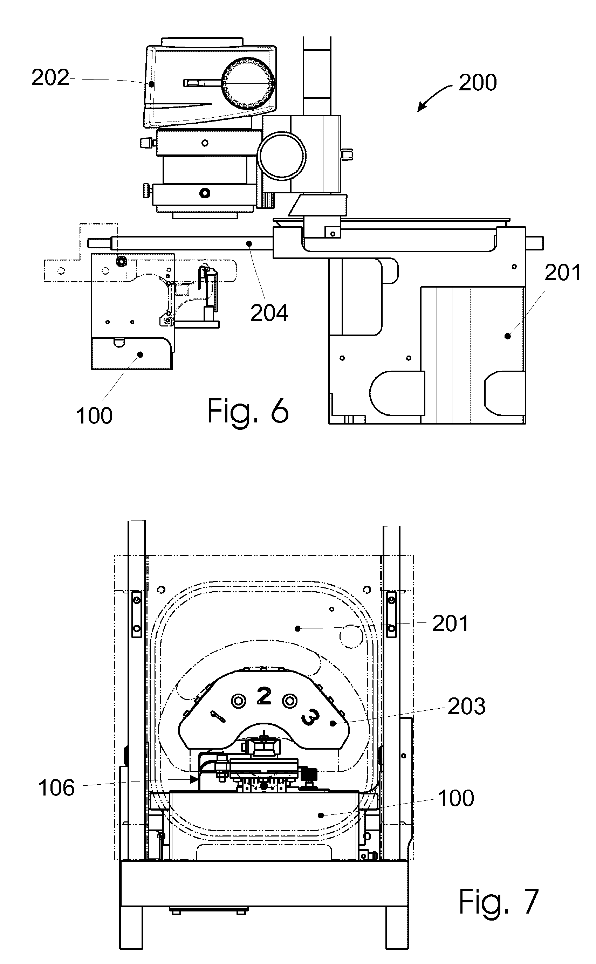

Die Fig. 5 und 6 zeigen jeweils Seitenansichten einer geöffneten Ionenstrahlätzanlage 200 mit dem darin montierten Probentischflansch 100. Der Probentischflansch 100 wird bei Inbetriebnahme der Ionenstrahlätzanlage 200 an der Vakuumkammer 201 (Rezipient), in welcher die Ionenquellen angeordnet sind, angeschlossen (siehe Fig. 7, welche einen Schnitt durch eine geschlossene Vakuumkammer 201 mit angeschlossenem Probentischflansch 100 zeigt). Zurückkommend auf die Fig. 5 und 6, ist der Probentischflansch 100 zur Probenjustierung um 90° kippbar gelagert. Die Probe wird vor dem Anlegen des Vakuums und vor Beginn des Ionenstrahlätzvorgangs auf dem Probentisch 102 befestigt und manuell relativ zur Maske justiert. In der Fig. 5 befindet sich der Probentischflansch 100 in einer ersten, um 90° gekippten Justierposition. In der Fig.6 befindet sich der Probentischflansch 100 in seiner zweiten Justierposition, wobei diese Justierposition auch die Position darstellt, in welcher der Probentischflansch 100 anschließend mittels einer Tragschiene 204 horizontal in Richtung Vakuumkammer 201 verschoben und an diese angeschlossen. Zum Probenjustierung weist die Ionenstrahlätzanlage 200 weiters ein Binokular 202 auf.

Nach dem Beladen und Justieren der Probe wird der Probentischflansch 100 an den Rezipienten der Ionenstrahlätzanlage 200 angeschlossen und die Probenkammer zum Herstellen eines Hochvakuums (üblicherweise zumindest 10⁻⁶ mbar) abgepumpt. Die Fig. 7 zeigt eine Draufsicht durch einen Schnitt durch die geschlossene Vakuumkammer 201 mit angeschlossenem Probentischflansch 100. Das Ätzverfahren erfolgt gemäß dem oben im Stand der Technik genannten Ionenstrahl-Böschungsätzverfahren aus der WO 2008/106815 A2 und folglich sind wie in der WO 2008/106815 A2 beschrieben drei Ionenstrahlen, die in einer Ionenquelle 203 integriert sind, unter einem vorgegebenen Winkel zueinander auf die Probenoberfläche geführt.

Nach dem Herstellen des Vakuums in der Vakuumkammer 201 wird die Probe auf die gewünschte Temperatur abgekühlt und mit den Ionenstrahlen bearbeitet. Während der Bearbeitung der Probe wird die Probentemperatur durch Regelung konstant auf einem gewünschten Temperaturwert gehalten. Nach Fertigstellung der Probe wird diese auf einen gewünschten Temperaturwert, vorzugsweise Raumtemperatur, aufgeheizt, um eine Kontamination mit Kondenswasser beim Belüften und Öffnen des Probentischflansches 100 zu vermeiden.

Im den folgenden Figuren 8 bis 13 sind die Regelkreise zum Regeln der Temperatur während des Ionenstrahlätzverfahrens näher beschrieben. Der Kühlvorrichtung 101 ist hierfür eine zentrale Temperaturregeleinrichtung (Steuerung) zugeordnet, welche für die Regelung der unten genannten Regelkreise und deren Varianten beim Abkühlen und Aufheizen zuständig ist. Das in den Fig. 8 bis 12 bezeichnete Feld "Wärme" bezeichnet die äußeren Wärmeeinflüsse, die auf den Probentisch 102 bzw. den Verdampfer 109 einwirken.

Fig. 8 zeigt eine erste Variante eines Schaltbilds eines Regelkreises zum Regeln der Temperatur der Probe. Bei dieser Variante ist dem Probentisch 102 ein Temperaturfühler 122 (Temp.-sensor 122) zugeordnet, welcher den Istwert der Probentemperatur misst. Die Steuerung regelt die Temperatur des gekühlten Probentisches über die Pumpendrehzahl (Pumprate) der Kühlmittelpumpe auf eine vom Bediener vorgebbare Sollwert-Temperatur. Die Temperatur des Probentisches 102 wird somit über die Durchflussrate des flüssigen Stickstoffs durch den Kühlfinger 105 geregelt.

Fig. 9 zeigt eine zweite Variante eines Schaltbilds eines Regelkreises zum Regeln der Temperatur der Probe. Auch bei dieser Variante ist dem Probentisch 102 ein Temperaturfühler 122 (Temp.-Sensor 122) zugeordnet, welcher den Istwert der Probentemperatur misst. Weiters ist dem Probentisch 102 zusätzlich ein Heizelement 116 zugeordnet. Die Steuerung regelt die Temperatur des gekühlten Probentisches 102 mit Hilfe des Heizelements 116 auf eine vom Bediener vorgebbare Sollwert-Temperatur. Wie oben bereits erwähnt liegt der Vorteil der zweiten Variante gegenüber der ersten Variante darin, dass auf gewünschte Änderungen der Temperatur rascher reagiert werden kann.

Fig. 10 zeigt ein Schaltbild eines Regelkreises zum Regeln der Temperatur des Verdampferblocks 109. Dem Verdampferblock 109 ist ein Temperaturfühler 118 (Temp.-Sensor 118) zugeordnet, der den Istwert der Verdampferblocktemperatur misst. Die Steuerung regelt die Temperatur des gekühlten Verdampferblocks 109 über die Pumpendrehzahl (Pumprate) der Kühlmittelpumpe 121 auf eine vom Bediener vorgebbare Sollwert-Temperatur. Die Temperatur des Verdampferblocks 109 wird somit über die Durchflussrate des flüssigen Stickstoffs durch den Kühlfinger 105 geregelt. Insbesondere wird die Temperatur des Verdampferblocks 109 mittels der Pumpendrehzahl der Kühlmittelpumpe so geregelt, dass sie knapp unterhalb der Fließtemperatur des Kühlmittels in Form von flüssigem Stickstoff, das heißt ungefähr zwischen -190°C und - 195°C, gehalten wird, so dass das Kühlmittel nur gasförmig aus dem Auslass 117 des Verdampferblocks 109 austritt.

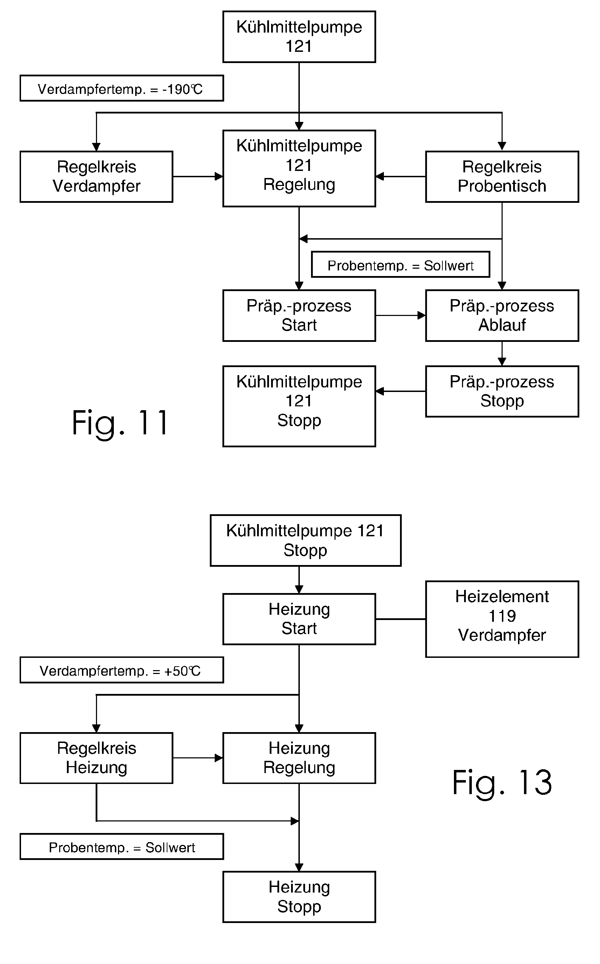

Fig. 11 zeigt ein Schaltbild, welches die Ablaufsteuerung der Kühlung darstellt. Zu Beginn der Kühlung wird die Kühlmittelpumpe angeschalten (Kühlmittelpumpe Start). Die Temperatur des Probentisches 102 (Regelkreis Probentisch - siehe Fig. 6) und des Verdampferblockes 109 (Regelkreis Verdampfer - siehe Fig. 8) werden über die Pumpendrehzahl der Kühlmittelpumpe 121 (Kühlmittelpumpe-Regelung) auf eine vom Bediener vorgebbare Sollwert-Temperatur wie oben in Fig. 6 und Fig. 8 beschrieben, geregelt. Zu Beginn (Präp.-prozess Start) wird die Probe auf eine gewünschte Temperatur herabgekühlt. Erst wenn diese erreicht ist, erfolgt eine automatische Freigabe für den Ionenstrahlätz-Präparationsprozesses (Präp.-prozess Ablauf). Sobald der Präparationsprozess abgeschlossen ist (Präp.-prozess Stopp) wird die Kühlung durch Abschalten der Kühlmittelpumpe gestoppt (Kühlmittelpumpe Stopp).

Fig. 12 zeigt ein Schaltbild eines Regelkreises zum Regeln der Temperatur beim Aufheizen nach Beendigung des Ionenstrahlätzvorgangs und Fig. 13 ein Schaltbild der Ablaufsteuerung des Aufheizens mittels des in Fig. 12 dargestellten Regelkreises. Die folgende Beschreibung bezieht sich auf Fig. 12 und Fig. 13. Dem Verdampferblock ist ein Heizelement 119 zugeordnet, welches ausschließlich zum Aufheizen des gesamten Probentischflansches 100 (d.h. einschließlich Probentisch 102, Maskenhalter 103 und Verdampferblock 109) dient, nicht aber zur Regelung der Temperatur während des Ionenstrahlätzvorgangs. Der in Fig. 10 dargestellte Regelkreis dient der Überwachung und Regelung des kontrollierten Aufheizens, um ein Niederschlagen der Luftfeuchte der Umgebungsluft auf der Probe zu verhindern. Vor dem Aufheizen wird die Kühlung durch Abschalten der Kühlmittelpumpe gestoppt (Kühlmittelpumpe Stopp). Das Aufheizen wird durch Einschalten des Heizelements 119 gestartet (Heizung Start). Das Heizelement 119 heizt mit maximaler Heizleistung den Verdampferblock 109 und über die Verbindung des Kühlfingers auch den Probentisch 102 samt Probe und den Maskenhalter 103 samt Maske 104 auf. Da das Heizelement 119 direkt im Verdampferblock 109 angeordnet ist, heizt dieser sich schneller auf als der weiter entfernte Probentisch 102 bzw. Maskenhalter 103. Erreicht der Verdampferblock 109 eine Temperatur von +50°C (Messung mittels Temperatursensor am Verdampferblock 109), dann wird die Temperatur mittels der Steuerung geregelt (Heizung Regelung). Die Steuerung hält dabei die Temperatur des Verdampferblocks 109 durch Drosselung der Heizleistung des Heizelements 119 konstant. Der Probentisch 102 und der Maskenhalter 103 werden weiter aufgeheizt bis ihre Solltemperatur, die zweckmäßigerweise die Raumtemperatur ist, erreicht wird (Messung mittels des Temperatursensors am Probentisch 102). Nach dem Erreichen der Solltemperatur des Probentisches 102 und des Maskenhalters 103 wird die Heizung beendet (Heizung Stopp) und der Probentischflansch 100 kann zur Probenentnahme belüftet und geöffnet werden.

Die Temperatur des Maskenhalters 103 wird nicht extra geregelt, da der Maskenhalter 103 ein annähernd gleiches Temperaturverhalten beim Abkühlen und beim Aufheizen wie der Probentisch 102 zeigt. Die Temperatur des Maskenhalters 103 ist also an die Regelung der Temperatur des Probentisches gekoppelt und wird folglich nicht extra überwacht.

Darüber hinaus wird der Kühlmittelfüllstand im Vorratsbehältnis (Dewargefäß) überwacht. Ist der Füllstand zu niedrig erfolgt eine Warnung an den Bediener. Diese Warnung kann optisch und/oder akustisch erfolgen. Unterschreitet der Füllstand einen kritischen Wert wird der Kühlprozess abgebrochen bzw. kann nicht gestartet werden.

Die oben beschriebenen Verwirklichungen der Erfindung sind nur Beispiele unter vielen und sind folglich nicht als einschränkend zu betrachten.

## Patentansprüche

1. Kühlvorrichtung (101) für eine Probe in einem Ionenstrahlätzverfahren, mit einem Probentisch (102) zum Anordnen der Probe, einem ein Kühlmittel enthaltendes Kühlmittelbehältnis (120) und zumindest einem Wärmeleitelement (106a,106b) zum Kühlen der Probe mit Hilfe des Kühlmittels,
weiterhin enthaltend einen Kühlfinger (105), der mit dem zumindest einen Wärmeleitelement (106a,106b) wärmeschlüssig verbunden ist, wobei der Probentisch (102) über das zumindest eine Wärmeleitelement (106a, 106b) mit dem Kühlfinger (105) wärmeschlüssig verbunden ist, und wobei der Kühlfinger (105) einen vom Kühlmittel durchströmbaren Kanal (130,131) aufweist, der mit dem Kühlmittelbehältnis (120) verbunden ist, und
zumindest ein weiteres Wärmeleitelement (106c), welches sich von dem Kühlfinger (105) zu einer Maskenhalterungseinrichtung (103) für eine Maske (104) erstreckt.

2. Kühlvorrichtung nach Anspruch 1, **dadurch gekennzeichnet, dass** sie ein Mittel (121) zum Steuern des Kühlmittelflusses aufweist.

3. Kühlvorrichtung nach Anspruch 2, **dadurch gekennzeichnet, dass** das Mittel zum Steuern des Kühlmittelflusses als Kühlmittelpumpe (121) ausgebildet ist.

4. Kühlvorrichtung nach einem der Ansprüche 1 bis 3, **dadurch gekennzeichnet, dass** der Kühlfinger (105) doppelwandig ausgebildet ist.

5. Kühlvorrichtung nach einem der Ansprüche 1 bis 4, **dadurch gekennzeichnet, dass** die Probe relativ zur Maske positionierbar ist.

6. Kühlvorrichtung nach einem der Ansprüche 1 bis 5, **dadurch gekennzeichnet, dass** der Kanal (130,131) des Kühlfingers (105) in einen Verdampferblock (109) zum Verdampfen des aus dem Kühlfinger (105) ausströmenden Kühlmittels mündet.

7. Kühlvorrichtung nach Anspruch 6, **dadurch gekennzeichnet, dass** dem Verdampferblock (109) ein Temperaturmessmittel (118) zum Messen der Temperatur des Verdampferblocks und/ oder ein Heizelement (119) zugeordnet sind.

8. Kühlvorrichtung nach einem der Ansprüche 1 bis 7, **dadurch gekennzeichnet, dass** dem Probentisch (102) ein Temperaturmessmittel (122) zum Messen der Temperatur des Probentischs (102) und/ oder ein Heizelement (116) zugeordnet sind.

9. Kühlvorrichtung nach Anspruch 7 oder 8, **dadurch gekennzeichnet, dass** ihr eine Temperaturregeleinrichtung zum Regeln der Temperatur des Probentisches (102) und/ oder der Temperatur des Verdampferblocks (109) zugeordnet ist, wobei ein der Temperatur des Probentisches (102) und/oder der Temperatur des Verdampferblocks (109) entsprechendes Signal der Temperaturregeleinrichtung zugeführt ist, welche die Temperatur des Probentisches (102) und/oder die Temperatur des Verdampferblocks (109) auf einen vorgebbaren Wert regelt.

10. Kühlvorrichtung nach den Ansprüchen 3 und 9, **dadurch gekennzeichnet, dass** die Temperaturregeleinrichtung die Temperatur des Probentisches (102) und/oder des Verdampferblockes (109) über die Pumpendrehzahl der Kühlmittelpumpe (121) auf einen vorgebbaren Wert regelt.

11. Kühlvorrichtung nach Anspruch 9 oder 10, **dadurch gekennzeichnet, dass** die Temperaturregeleinrichtung die Temperatur des Probentisches (102) mittels des dem Probentisch (102) zugeordneten Heizelements (116) auf einen vorgebbaren Wert regelt.

12. Kühlvorrichtung nach einem der Ansprüche 9 bis 11, **dadurch gekennzeichnet, dass** die Temperaturregeleinrichtung die Temperatur des Probentisches (102) und des Verdampferblockes (109) mittels des dem Verdampferblock (109) zugeordneten Heizelements (119) nach Beendigen des Ionenstrahlätzvorgangs auf einen Temperaturwert regelt, bei welchem ein Niederschlagen der Luftfeuchte der Umgebungsluft auf der Probe verhindert wird.

13. Verfahren zum Einstellen der Temperatur einer Probe in einem Ionenstrahlätzverfahren, die Schritte umfassend:
(a) Befestigen einer Probe auf einem kühlbaren Probentisch (102) einer Ionenstrahlätzvorrichtung, wobei der Probentisch (102) einer Kühlvorrichtung nach einem der Ansprüche 1 bis 12 zugeordnet ist, und Justieren der Probe auf dem Probentisch (102).
(b) Abkühlen der Probe mittels des durch den Kanal (131,132) des Kühlfingers geleiteten Kühlmittels, wobei eine für den Ionenstrahlätzvorgang gewünschte Temperatur eingestellt wird.

14. Verfahren nach Anspruch 13, mit einem auf Schritt (b) folgenden Schritt (c), bei welchem nach Beendigung des Ionenstrahlätzvorgangs die Kühlung der Probe beendet wird.

15. Verfahren nach Anspruch 14, mit einem auf Schritt (c) folgenden Schritt (d), bei welchem die Probe auf eine Temperatur aufgewärmt wird, bei welcher ein Niederschlagen der Luftfeuchte der Umgebungsluft auf der Probe verhindert wird, vorzugsweise auf Raumtemperatur.

16. Verfahren nach einem der Ansprüche 13 bis 15, **dadurch gekennzeichnet, dass** die Probe relativ zu einer Maske (104) justiert wird, wobei die Maske (104) analog zur Probe abgekühlt bzw. wieder auf Raumtemperatur aufgewärmt wird.

17. Verfahren nach einem der Ansprüche 13 bis 16, **dadurch gekennzeichnet, dass** die Temperatur während des Ionenstrahlätzvorgangs konstant gehalten wird.

18. Verfahren nach einem der Ansprüche 13 bis 17, **dadurch gekennzeichnet, dass** das Kühlmittel ein Flüssiggas ist, vorzugsweise flüssiger Stickstoff oder flüssige Luft.

19. Verfahren nach Anspruch 18, **dadurch gekennzeichnet, dass** die Durchflussrate des Kühlmittels so eingestellt wird, dass nach Durchfließen eines Verdampferblocks (109) das Kühlmittel nur mehr gasförmig aus diesem austritt.

## Claims

1. Cooling device (101) for a sample in an ion beam etching process, having a sample table (102) for the arrangement of the sample, a coolant container (120) containing a coolant, and at least one thermally conductive element (106a, 106b) for cooling the sample with the aid of the coolant, further containing a cooling finger (105), which is connected in a heat-conducting manner to the at least one thermally conductive element (106a, 106b), wherein the sample table (102) is connected in a heat-conducting manner to the cooling finger (105) via the at least one thermally conductive element (106a, 106b), and wherein the cooling finger (105) has a channel (130, 131) through which coolant flows and which is connected to the coolant container (120), and
at least one further thermally conductive element (106c), which extends from the cooling finger (105) to a mask holding device (103) for a mask (104).

2. Cooling device according to Claim 1, **characterized in that** it has a means (121) for controlling the coolant flow.

3. Cooling device according to Claim 2, **characterized in that** the means for controlling the coolant flow is formed as a coolant pump (121).

4. Cooling device according to one of Claims 1 to 3, **characterized in that** the cooling finger (105) is of twin-wall construction.

5. Cooling device according to one of Claims 1 to 4, **characterized in that** the sample can be positioned relative to the mask.

6. Cooling device according to one of Claims 1 to 5, **characterized in that** the channel (130, 131) of the cooling finger (105) opens into an evaporator block (109) for evaporating the coolant flowing out of the cooling finger (105).

7. Cooling device according to Claim 6, **characterized in that** a temperature measuring means (118) for measuring the temperature of the evaporator block and/or a heating element (119) is/are assigned to the evaporator block (109).

8. Cooling device according to one of Claims 1 to 7, **characterized in that** a temperature measuring means (122) for measuring the temperature of the sample table (102) and/or a heating element (116) is/are assigned to the sample table (102).

9. Cooling device according to Claim 7 or 8, **characterized in that** it is assigned a temperature control device for controlling the temperature of the sample table (102) and/or the temperature of the evaporator block (109), wherein a signal corresponding to the temperature of the sample table (102) and/or the temperature of the evaporator block (109) is fed to the temperature control device, which controls the temperature of the sample table (102) and/or the temperature of the evaporator block (109) to a predefinable value.

10. Cooling device according to Claims 3 and 9, **characterized in that** the temperature control device controls the temperature of the sample table (102) and/or the evaporator block (109) to a predefinable value via the rotational speed of the coolant pump (121).

11. Cooling device according to Claim 9 or 10, **characterized in that** the temperature control device controls the temperature of the sample table (102) to a predefinable value by means of the heating element (116) assigned to the sample table (102).

12. Cooling device according to one of Claims 9 to 11, **characterized in that**, after the ion beam etching process has been completed, the temperature control device controls the temperature of the sample table (102) and the evaporator block (109), by means of the heating element (119) assigned to the evaporator block (109), to a temperature value at which deposition on the sample of the atmospheric humidity from the surrounding air is prevented.

13. Method for setting the temperature of a sample in an ion beam etching process, the steps comprising:
(a) fixing a sample on a coolable sample table (102) of an ion beam etching device, wherein the sample table (102) is assigned a cooling device according to one of Claims 1 to 12, and adjusting the sample on the sample table (102),
(b) cooling the sample by means of the coolant led through the channel (131, 132) of the cooling finger, wherein a temperature desired for the ion beam etching process is set.

14. Method according to Claim 13, with a step (c) following step (b), in which the cooling of the sample is ended following the completion of the ion beam etching process.

15. Method according to Claim 14, with a step (d) following step (c), in which the sample is heated to a temperature at which deposition on the sample of the atmospheric humidity from the surrounding air is prevented, preferably to room temperature.

16. Method according to one of Claims 13 to 15, **characterized in that** the sample is adjusted relative to a mask (104), wherein the mask (104) is cooled and heated to room temperature again in a manner analogous to the sample.

17. Method according to one of Claims 13 to 16, **characterized in that** the temperature is kept constant during the ion beam etching process.

18. Method according to one of Claims 13 to 17, **characterized in that** the coolant is a liquid gas, preferably liquid nitrogen or liquid air.

19. Method according to Claim 18, **characterized in that** the flow rate of the coolant is set in such a way that, after it has flowed through an evaporator block (109), the coolant no longer emerges from the latter in gaseous form.

## Revendications

1. Dispositif de refroidissement (101) pour un échantillon dans un procédé d'attaque chimique par faisceau d'ions, comportant une table d'échantillons (102) pour disposer l'échantillon, un contenant (120) de liquide de refroidissement contenant un milieu de refroidissement et au moins un élément de conduction thermique (106a,106b) pour refroidir l'échantillon à l'aide du liquide de refroidissement, contenant en outre un doigt de refroidissement (105), qui est relié par conjonction thermique avec au moins un élément de conduction thermique (106a,106b), dans lequel la table d'échantillons (102) est reliée par conjonction thermique par l'intermédiaire de l'au moins un élément de conduction thermique (106a,106b) avec le doigt de refroidissement (105), et dans lequel le doigt de refroidissement (105) présente un canal traversé par le liquide de refroidissement (130,131) qui relié avec le contenant de liquide de refroidissement (120) et au moins un élément de conduction thermique supplémentaire (106c) qui s'étend à partir du doigt de refroidissement (105) dans une direction de support de masque (103) pour un masque (104).

2. Dispositif de refroidissement selon la revendication 1, **caractérisé en ce qu'**il présente un moyen (121) pour commander le flux de liquide de refroidissement.

3. Dispositif de refroidissement selon la revendication 2, **caractérisé en ce que** le moyen de commande de flux de liquide de refroidissement est conçu en tant que pompe de liquide de refroidissement (121).

4. Dispositif de refroidissement selon une des revendications 1 à 3, **caractérisé en ce que** le doigt de refroidissement (105) a une configuration à double paroi.

5. Dispositif de refroidissement selon une des revendications 1 à 4, **caractérisé en ce que** l'échantillon est positionnable relativement au masque.

6. Dispositif de refroidissement selon une des revendications 1 à 5, **caractérisé en ce que** le canal (130,131) du doigt de refroidissement (105) débouche dans un bloc d'évaporateur (109) pour évaporer le liquide de refroidissement s'écoulant hors du doigt de refroidissement (105).

7. Dispositif de refroidissement selon la revendication 6, **caractérisé en ce que** le bloc d'évaporateur (109) est associé à un moyen de mesure de température (118) pour mesurer la température du bloc d'évaporateur et/ou à un élément chauffant (119).

8. Dispositif de refroidissement selon une des revendications 1 à 7, **caractérisé en ce que** la table d'échantillons (102) est associée à un moyen de mesure de température (122) pour mesurer la température de la table d'échantillons (102) et/ou à un élément chauffant (116).

9. Dispositif de refroidissement selon la revendication 7 ou 8, **caractérisé en ce qu'**il est associé à un dispositif de régulation de température pour réguler la température de la table d'échantillons (102) et/ou la température du bloc d'évaporateur (109), dans lequel un signal correspondant à la température de la table d'échantillons (102) et/ou à la température du bloc d'évaporateur (109) est introduit dans le dispositif de régulation de température, qui règle la température de la table d'échantillons (102) et/ou la température du bloc d'évaporateur (109) sur une valeur pouvant être prédéfinie.

10. Dispositif de refroidissement selon les revendications 3 et 9, **caractérisé en ce que** le dispositif de régulation de température régule sur une valeur pouvant être prédéfinie la température de la table d'échantillons (102) et/ou du bloc d'évaporateur (109) par l'intermédiaire de la vitesse de rotation de pompe de la pompe de liquide de refroidissement (121).

11. Dispositif de refroidissement selon la revendication 9 ou 10, **caractérisé en ce que** le dispositif de régulation de température régule sur une valeur pouvant être prédéfinie la température de la table d'échantillons (102) au moyen de l'élément chauffant (116) associé à la table d'échantillons (102).

12. Dispositif de refroidissement selon une des revendications 9 à 11, **caractérisé en ce que** le dispositif de régulation de température règule la température de la table d'échantillons (102) et du bloc d'évaporateur (109) au moyen de l'élément chauffant (119) associé au bloc d'évaporateur (109) après la fin du processus d'attaque chimique par faisceau d'ions, dans lequel une précipitation de l'humidité d'air de l'air ambiant sur l'échantillon est empêchée.

13. Procédé de réglage de la température d'un échantillon dans un procédé d'attaque chimique par faisceau d'ions, les étapes comprenant de :
(a) fixer un échantillon sur une table d'échantillons (102) pouvant être refroidie d'un dispositif d'attaque chimique par faisceau d'ions, la table d'échantillons (102) étant associée à un dispositif de refroidissement selon une des revendications 1 à 12, et ajuster l'échantillon sur la table d'échantillons (102),
(b) refroidir l'échantillon au moyen du liquide de refroidissement guidé à travers le canal (131,132) du doigt de refroidissement, une température souhaitée pour le processus d'attaque chimique par faisceau d'ions étant réglée.

14. Procédé selon la revendication 13, avec une étape (c) suivant l'étape (b), dans lequel après la fin du processus d'attaque chimique par faisceau d'ions le refroidissement de l'échantillon est terminé.

15. Procédé selon la revendication 14, avec une étape (d) suivant l'étape (c), dans lequel l'échantillon est chauffé à une température, à laquelle une précipitation de l'humidité d'air de l'air ambiant sur l'échantillon est empêchée, de préférence à la température de la pièce.

16. Procédé selon une des revendications 13 à 15, **caractérisé en ce que** l'échantillon est ajusté relativement à un masque (104), le masque (104) étant refroidi, respectivement réchauffé à nouveau à la température de la pièce de manière analogue à l'échantillon.

17. Procédé selon une des revendications 13 à 16, **caractérisé en ce que** la température est maintenue constante pendant le processus d'attaque chimique par faisceau d'ions.

18. Procédé selon une des revendications 13 à 17, **caractérisé en ce que** le liquide de refroidissement est un gaz liquide, notamment de l'azote liquide ou de l'air liquide.

19. Procédé selon la revendication 18, **caractérisé en ce que** le débit du liquide de refroidissement est réglé de telle sorte que, après l'écoulement à travers un bloc d'évaporateur (109), le liquide de refroidissement ne peut plus ressortir de ce dernier que sous forme gazeuse.
